# EUROPEAN PATENT SPECIFICATION

(11) **EP 3 099 973 B1**
(45) Date of publication and mention of the grant of the patent: **03.05.2017**
(21) Application number: 15722700.0
(22) Date of filing: 08.05.2015
(51) Int. Cl.: F21V 7/00, F21V 19/00, F21Y 105/10, F21Y 115/10

(54) **CONFORMAL COATED LIGHTING OR LUMINATION SYSTEM**
OBERFLÄCHENTREU BESCHICHTETES BELEUCHTUNG ODER LEUCHTSYSTEM
DISPOSITIF OU SYSTÈME D'ÉCLAIRAGE POURVU D'UN REVETEMENT CONFORME

(30) Priority: 20.05.2014 EP 14169071
(43) Date of publication of application: 07.12.2016
(73) Proprietor: Philips Lighting Holding B.V., 5656 AE Eindhoven (NL)
(72) Inventor: DE SAMBER, Marc Andre, NL-5656 AE Eindhoven (NL); VAN GRUNSVEN, Eric Cornelis Egbertus, NL-5656 AE Eindhoven (NL); JACOBS, Egbertus Reinier, NL-5656 AE Eindhoven (NL); JANSSEN, Esther Anna Wilhelmina Gerarda, NL-5656 AE Eindhoven (NL)
(74) Representative: Verweij, Petronella Daniëlle
(86) International application number: PCT/EP2015/060158
(87) International publication number: WO 2015/176972

(56) References cited:
- EP-A2- 0 364 806
- DE-U1-202005 018 155
- US-A1- 2002 141 181
- US-A1- 2013 056 749
- US-A1- 2013 114 255

## Description

### FIELD OF THE INVENTION

The present invention relates to a lighting device and a method for manufacturing such a lighting device.

### BACKGROUND OF THE INVENTION

Fluorescent and incandescent lighting are commonly used lighting technologies for various lighting-applications such as for example illumination of an office space or a shopping mall. However, incandescent lighting is not competitively energy efficient and fluorescent lighting-tubes commonly contain environmentally unfriendly elements that are not easily disposed of. In recent years, light-emitting diodes (LEDs) have emerged as a strong competitor on the market for lighting-applications, mainly due to their superior energy efficiency over other existing technologies.

In recent years, there has been a growing interest for personalized light-emitting devices having e.g. odd or unconventional shapes. For such personalized light-emitting devices, which are typically not made in large numbers, a challenge is to keep the cost down per manufactured unit while meeting the customer demand. A common realization of such lighting device utilizes a number of LEDs which can be made relatively small and guiding elements for distributing the light emitted by the LEDs, over a desired shape of the light-emitting device.

US20090114928 discloses a lighting structure comprising an array of LEDs. In the lighting structure, the array of LEDs is arranged between layers of conductive material forming electrodes for the LEDs, and between glass sheets through which light is transmitted. Each of the LEDs is arranged in a hole in an intermediate layer of the structure.

US2013/056749A1 discloses an illumination system formed by aligning light-emitting elements with optical elements and/or disposing light-conversion materials on the light-emitting elements, as well as by providing electrical connectivity to the light-emitting elements.

However, in the prior art, including US20090114928, there is still a lack of knowledge for fully meeting the demand of personalized light-emitting devices. For example, the disclosed lighting structure of US20090114928 is not satisfying for manufacturing odd-shaped lighting devices due to e.g. a relatively complicated contact and connection configuration and relatively complicated assembly procedure.

### SUMMARY OF THE INVENTION

In view of the above-mentioned and other drawbacks of the prior art, a general object of the present invention is to provide an improved method for manufacturing lighting devices which may be odd-shaped, and to provide such a lighting device. The object is obtained by the subject-matter of the claims. According to a first aspect of the invention, there is provided a lighting device comprising:
a template comprising a plurality of cavities distributed across the template, wherein each cavity has an opening in a top surface of the template;
a plurality of light source packages, each comprising a light source, arranged in each of the cavities, wherein each of the plurality of light source packages has a shape matching a shape of a corresponding cavity, each of the light source packages having a first and a second electrode arranged at a top surface of the light source package and being exposed at the opening of the cavity electrically connected to the light source; and
electrical conductors applied on a top surface of the template, the electrical conductors contacting the first and second electrodes of the light source packages for electrically connecting the light source packages,
wherein the light source packages or the plurality of cavities comprise a reflective bottom layer and wherein a light emitting surface of the light source faces the reflective bottom layer.

According to a second aspect of the present invention there is provided a method for manufacturing a lighting device, the method comprising the steps of:
providing a template comprising a plurality of cavities distributed across the template, wherein each cavity has an opening in a top surface of the template;
arranging a plurality of light source packages, each comprising a light source, in the cavities, wherein each of the light source packages has a shape matching a shape of a corresponding cavity, each of the light source packages having a first and a second electrode electrically connected to the light source, the first and the second electrodes being arranged at a first surface of the light source package and being exposed at the opening of the cavity when the plurality of light source packages are arranged in the cavities; and
after arranging the plurality of light source packages in the cavities, applying electrical conductors on the top surface of the template layer, the electrical conductors contacting the first and second electrodes of the light source packages for electrically connecting the light source packages,
wherein the light source packages or the plurality of cavities comprise a reflective bottom layer and wherein a light emitting surface of the light source faces the reflective bottom layer.

Effects and features of both aspects of the present invention are largely analogous.

The template with the cavities defines a layout of the light source packages of the lighting device. Thus, the cavities in the template indicate positions in the template where the light source packages are arranged. In embodiments, one light source package is arranged in one cavity and in each cavity one light source package is arranged. Furthermore, the top surface of the template comprises an opening for each cavity. When arranging the light source packages in the cavities, the light source packages are inserted into the cavity via the opening. The first surface of the light source packages may protrude outside the opening of the cavity, thus, above the top surface of the template, or the light source package may be fully inside the cavity, wherein the first surface of the light source package is arranged below the top surface of the template.

The electrodes of each light source package are arranged such that they are exposed at the opening of the cavity and thus at the top surface of the template meaning that the electrodes on the first surface of the light source package are contactable from the top surface of the template. The electrical conductors provide galvanic electrical connections to the electrodes of the light source package.

According to the invention, electrical conductors are arranged on the top surface of the template after the light source packages have been arranged in the cavities. This means that the electrodes of the light source packages are exposed at the top surface in a way that the electrical conductors, applied after the light source packages are in place in the cavities, may electrically contact the first and the second electrodes of the light source packages.

The present invention is based on the realization that a nearly arbitrarily shaped lighting device may be manufactured by a method comprising forming electrical connections after the light source packages comprising the light sources have been placed. Furthermore, the inventors have realized that an improved, simple manufacturing method and lighting device is possible by using a template comprising cavities such that predefined positions for the light source packages are made. Moreover, by matching the shape of the light source packages with a shape of the cavities, an improved self-assembly like process for proper fitting of the light source packages in the cavities is realized. Thereby, a cost effective manufacturing method for personalized lighting devices is realized.

A reflective bottom layer means that the bottom layer reflects the majority of light which is incident on the layer. In this case, the light source, in operation, emits light mainly towards the bottom layer. Furthermore, the bottom layer is arranged as a bottom layer of the light source package such that the bottom layer is adjacent to an inner surface of the corresponding cavity when the light source package is arranged in this cavity. In other words, the bottom layer of the light source is arranged such that when the light source package is arranged in the cavity, the bottom layer is arranged between the inner surface of the cavity and the light source. The bottom layer may be shaped like a contour of the light source package. Alternatively, the bottom layer is arranged as a bottom layer of the cavities. Furthermore, a light emitting surface of the light source faces the reflective bottom layer. Thus, the light source may be arranged under the first or the second electrode such that the light source may be hidden behind the first or second electrode of the light source package and is not visible from opposite of the electrodes, if viewing from an angle perpendicular to the top surface. In this case, in which the light source may be arranged under the first or the second electrode, the hidden light source makes the output light more uniform and esthetically appealing since no dark spots are caused by the mounting positions of the light sources. In this arrangement, the light sources emit light towards the reflective bottom layer, which reflects the emitted light back towards the top surface of the template and out from the cavity.

According to an embodiment of the invention, the template may be part of a supporting structure. A supporting structure may be a structure mechanically supporting the lighting device. For example, the supporting structure may be the main body of the lighting device. Having the template being part of the supporting structure means that the cavities, in which the light source packages are arranged, are provided in the supporting structure. Thus, the top surface is in this case the top surface of the supporting structure. An advantage of arranging the cavities directly in the supporting structure is that a lighting device having a curved or otherwise non-planar structure may be manufactured in a facilitated manner. For example, the supporting structure may partly define an overall shape of the lighting device. The supporting structure may be manufactured as a first step. The overall shape of the lighting device may for example be chosen by a user desiring a certain design of the lighting device. Subsequently, the cavities may be arranged in the supporting structure (thus acting as a template) having the non-planar shape. Such a shape may comprise a curved portion, a spherical portion, or other nearly arbitrary shapes, as long as the light source packages can be arranged in the cavities. Naturally, planar shapes are also possible.

The supporting structure may be fabricated using an additive manufacturing method comprising a printing method with the geometry of the supporting structure and the cavities being digitally designed. The printing method may for example be a 3D printing method.

Moreover, the reflective bottom layer may comprise a V-shaped or a U-shaped cross-section. The cross-section may be defined in a plane perpendicular to the template, when the light source package comprising the bottom layer is arranged in the cavity. The U-shaped or V-shaped cross-section facilitates correct placement of the light source package in the cavity having a shape matching the shape of the light source package. In this case, the shape of the cavity substantially matches the shape of the bottom layer. In one embodiment, each of the light source packages is shaped in the form of an elongated half-cylinder.

In a further embodiment of the invention, a top portion of the light source package is asymmetric with respect to a bottom portion of the light source package, wherein the shape of each of the light source packages is rotationally symmetric around a top-bottom axis. The top portion may for example comprise the electrodes and a portion adjacent to the electrodes. The bottom portion may comprise the remaining portion of the light source package excluding the top portion. For example, the top portion may be the upper half of the light source package and the bottom portion may be the lower half of the light source package. Furthermore, the rotational symmetry around the top-bottom axis enables an easy fitting and alignment of the light source package in the cavity having a matching shape. The rotational symmetry may for example allow 2, 3, 4, 5, or more different configurations depending on the level of symmetry, but still being able to properly assemble the lighting device. This advantageously improves e.g. capture efficiency for a self-assembly process. Examples of rotational symmetry is e.g. along 180° rotations or 90° rotations but other are possible.

In embodiments of the invention the light source package may comprise two or light sources.

In one embodiment of the invention, each light source package comprises two light sources, wherein each light source is connected to two electrodes.

In another embodiment of the invention, each light source package comprises two solid state light sources, for example LEDs, connected anti-parallel and connected to two electrodes to enable driving the light source packages with an AC power source.

According to embodiments of the invention the first and second electrodes of the light source packages extend onto the top surface of the template. Thus, the electrodes extend on the top surface meaning that there is an overlap between the top surface and the electrodes of the light source package. In this way, contacting the light sources with the electrical conductors is facilitated since for example the contact surface between the electrical conductors and the electrodes of the light source package may be increased. Furthermore, more relaxed geometrical tolerances when applying the electrical conductors are possible by allowing the electrodes of the light source package to extend on the top surface of the template.

According to one embodiment of the invention, the template is a separate template layer which is arranged on a supporting structure. In other words, in this case the template is a distinct part which is arranged on the supporting structure. The supporting structure may also in this case be curved or non-planar, but a planar supporting structure is also possible. With a separate template layer, the cavities are formed in the template layer, not in the supporting structure. The template layer, when applied as a separate layer, may be made from e.g. silicone, epoxy or PUR (polyurethane), or may be a hot melt type to allow reflowing of the material of the template to close gaps between the material and the light source packages. Having a separate template layer allows manufacturing specific, personalized, lighting products in low volumes (i.e. low number of produced units) that are based upon a small number of different starting support structures, a template layer, and light source packages. The supporting structure may give the mechanical structure, but also provide other functions such as for example thermal heat sinking. The template layer may offer (within a set of design rules and possible circuitry combinations) the personalized product geometry and light design. The light source package may comprise standardized parts, comprising light emitting diodes. The combination of the supporting structure, the template layer, and the light source package provides personalized design (freedom of design), and multiple end products (satisfying the user's preference) become possible, based on a low number of building bricks.

In one embodiment of the invention, the light source of each light source package comprises a top light source, electrically connected to a first top electrode and a second top electrode, and a bottom light source electrically connected to a first and a second bottom electrode wherein the first and second bottom electrodes are arranged on a surface of the light source package that is opposite to a surface on which the first and second top electrodes are arranged. This way, when arranging the light source packages in the cavities, an improved self-assembly is provided since the light source packages may be arranged with either side up or down in the cavity but still have the electrodes of a light source arranged towards the opening of the cavity. Thus, as long as the light source package is arranged in the cavity such that the shape of the light source package matches the shape of the cavity, the electrodes of a light source will be arranged facing up towards the opening of the cavity. Thereby a facilitated way of arranging the light source packages in the cavities is provided.

In embodiments an adhesion element is provided in the cavities in order to attach the light source packages in the cavities. The adhesion element is provide in the cavities before each of the light source packages is arranged in the corresponding cavity. The adhesion element is configured to attach each of the light source packages in the cavity. The adhesion element may be in the form of e.g. droplet, or a layer. In case of a droplet, the droplet is placed in the cavity before arranging the light source packages in the cavities. In case of a layer, the layer is arranged at the bottom of the cavity. The adhesion element, for example in the form of glue, may, after application, initially be non-sticky such that the light source packages may be correctly positioned in the cavities before the adhesion element is cured. In other words, the adhesion element captures and freezes only well-oriented and positioned light source packages. In one embodiment, the adhesion element may be arranged such that the adhesion element and the light source package are in contact only if the light source package is properly fit in the cavity. For example, the cavity may comprise an additional cavity extension and the light source package may comprise an additional package extension. The adhesion element may be arranged in the additional cavity extension of the cavity such that the light source package and the adhesion element only touch each other if the light source package is correctly arranged in the cavity and the additional package extension of the light source package extends into the additional cavity extension of the cavity. In this case, the adhesion element may be a sticky adhesion element. In case of an adhesion element in the form of a layer, the adhesion element may be applied using e.g. vision based volume jetting with intermediate B-stage level curing, pre-applied B-stage glue, e.g. prior to applying the template layer, if that is the case, B-stage glue pre-applied on the light source packages, or using the template layer material.

According to an embodiment of the invention, the light source package comprises a magnetic element. In an embodiment, the light source package may be properly fitted and firmly attached in the cavity via a (permanent) magnetic force. In an embodiment a magnetic field is applied when arranging the light source package in the cavity, such that the light source package is attracted towards the cavities in the template. The magnetic element may for example be arranged as part of a bottom layer of the light source package, as part of the lead frame, or as an additional magnetic element arranged inside the light source package. In case of the magnetic element being part of the bottom layer, the bottom layer may for example be made from a magnetic (ferro-magnetic) reflective material. Furthermore, the lead frame may be made partly from a magnetic material such as e.g. Fe or Ni. Furthermore, the template and the light source packages are advantageously placed in a fluid before applying the magnetic field. In other words, the light source packages and the template are located in a fluid when the magnetic field is applied to the light source packages and the template. This allows a more controlled motion of the light source packages when the applied magnetic field is on. The fluid may be a liquid, however, naturally, the liquid should not damage the light source packages.

In other embodiments, a cyclic magnetic field may be applied when arranging the light source packages in the cavities. In this case, the light source packages, which are, at a first stage, incorrectly fitted with the corresponding cavity, may be removed from the cavity and are re-fitted by the cyclic magnetic field. The cyclic magnetic field may be configured to be operated in an on-off manner or in a way such that the direction of the magnetic field is repetitively reversed.

Furthermore, in one embodiment a mechanical means for assembling the light source packages is possible. In this embodiment, a slide tool such as e.g. a squeegee is used for re-fitting the light source packages in the cavities. For example, a badly fitted light source package would protrude from the cavity. By sliding the e.g. squeegee on the top surface, the squeegee then pushes the badly fitted light source package in place. Correctly arranged and fitted light source packages are almost flush with the top surface of the template, and thus do not protrude from the cavity above the top surface, and thus will remain in the cavity.

According to an embodiment of the invention, the shape of each of the light source packages is rotationally asymmetric around a top-bottom axis. The top bottom axis is defined to be perpendicular to the top surface of the template. With a rotationally asymmetric shape of the light source packages only one rotational mounting position in the matching cavities is possible. This improves a self-assembly and self-alignment process when arranging the light source packages in the cavities. Furthermore, this enables predictive positions of the electrodes of the light source packages, facilitating the process of applying the electrical conductors by knowing on beforehand the locations of the electrodes.

The step of applying electrical conductors may comprise forming conductor lines using a printing process. The conductor lines connect light sources packages with each other and/or the light source packages with electrical input/output leads configured to provide power to the light source packages from a power source.

For example, the first electrode of a first light source package of the light source packages may be electrically connected to the second electrode of a second light source package of the light source packages by means of an electrical conductor. In the above, the electrical connections are galvanic electrical connections.

According to various embodiments, the cavities may be of a first and a second type of cavities having a first and a second shape, wherein a first light source package having a shape matching the first cavity may be arranged in one of the first cavities, wherein a second light source package having a shape matching the second cavity may be arranged in one of the second cavities. The first and the second shapes are different shapes. In this way a more complex lighting device may be manufactured which may comprise light source packages with different properties, wherein each shape of a light source package corresponds to a different property. For example, the first light source package may comprise a first light source emitting light of a first color (e.g. in the red color range) and the second light source package may comprise a second light source emitting light of a second color (e.g. in the blue color range). Naturally more than two different types of cavities are possible allowing for more than two different types of light source packages. The different light source packages may be contacted by electrical conductors contacting only one type of light source packages (e.g. the first type) or more than one type (e.g. the first and the second type), or in combinations (e.g. some of the first type and some of the second type of light source packages).

According to various embodiments, one or more electrical component packages comprising an electrical component is/are additionally arranged in one or more cavities. The electrical component may for example be an active or passive electrical component. Examples of electrical components are a resistor, a 0-ohm resistor, a capacitor, a switch, a splitter, a photodiode, etc. In this way a further variation of an entire circuitry comprising the light source package is enabled with a given starting template. In one exemplary embodiment, the electrical component package may comprise an active switch. The active switch may be arranged such that the light sources of a portion of light source packages may be controlled to emit light independently of light sources of a second portion of light source packages. In this way, an optical pattern provided by light emitted from e.g. the first portion of light source packages and/or the second portion of light source packages may be modified in an active way. In embodiments the shapes of the light source packages and the shape of the electrical component packages are different and are arranged in correspondingly differently shaped cavities. In this way the shape of the cavity defines the type of package that is arranged in the cavity.

In one embodiment, the printed electrical conductors are made from Ag filled polymer tracks.

According to various embodiments of the invention, the light source packages are serial-electrically connected.

According to an embodiment of the invention, a top layer covers the template and the electrical conductors. The top layer may be optically transmissive which allows for at least part of the light emitted by a light-emitting device to pass through a material of the top layer. Optically transmissive may be e.g. transparent, semi-transparent, translucent, or combinations thereof. The top layer may provide protection for the underlying structures, for example the top layer may provide scratch protection, a humidity barrier. Furthermore, the top layer may provide fixation for the light source packages. In addition, the top layer may provide optical functionality, for example for creating diffuse light, for converting light color (e.g. blue to white), for mixing colors, etc. The top layer may be fabricated using a 3D printing method.

One possible function for the top layer is beam shaping or beam manipulation. For example, an opening in the top layer at the location of a light source package may be used for shaping the light beam emitted from the light source package. Another function of the top layer may be wave guiding. For example the top layer may comprise an additional structure (in this case mainly an optical functionality) including local (3D) variation in composition (e.g. refractive index, scattering, embedded phosphors for color conversion, etc.) and structure (e.g. micro-lenses, out coupling micro-structures, Fresnel optics, meso-optics, etc.).

A light source in accordance with the invention may advantageously be a solid state light emitting device, in which light is generated through recombination of electrons and holes. Examples of solid state light sources include light-emitting diodes (LEDs) and semiconductor lasers.

Further features of, and advantages with, the present invention will become apparent when studying the appended claims and the following description. The skilled person realize that different features of the present invention may be combined to create embodiments other than those described in the following, without departing from the scope of the present invention.

### BRIEF DESCRIPTION OF THE DRAWINGS

These and other aspects of the present invention will now be described in more detail, with reference to the appended drawings showing exemplary embodiments of the invention, wherein:
Figs. 1a-b schematically show an exemplary lighting device and steps for manufacturing a lighting device according to an embodiment of the present invention;
Figs. 2a-d illustrate an exemplary embodiment of the present invention;
Fig. 3 illustrates an exemplary embodiment of the present invention;
Figs. 4a-d schematically shows an exemplary lighting device and steps for manufacturing a lighting device according to an embodiment of the present invention;
Fig. 5 schematically illustrates an exemplary method for arranging light source packages in cavities according to an embodiment of the invention;
Fig. 6 illustrates an exemplary embodiment of the present invention; and
Fig. 7 illustrates an exemplary embodiment of the present invention;

### DETAILED DESCRIPTION

The present invention will now be described more fully hereinafter with reference to the accompanying drawings, in which currently preferred embodiments of the invention are shown. This invention may, however, be embodied in many different forms and should not be considered as limited to the embodiments set forth herein; rather, these embodiments are provided for thoroughness and completeness, and fully convey the scope of the invention to the skilled addressee. Like reference characters refer to like elements throughout.

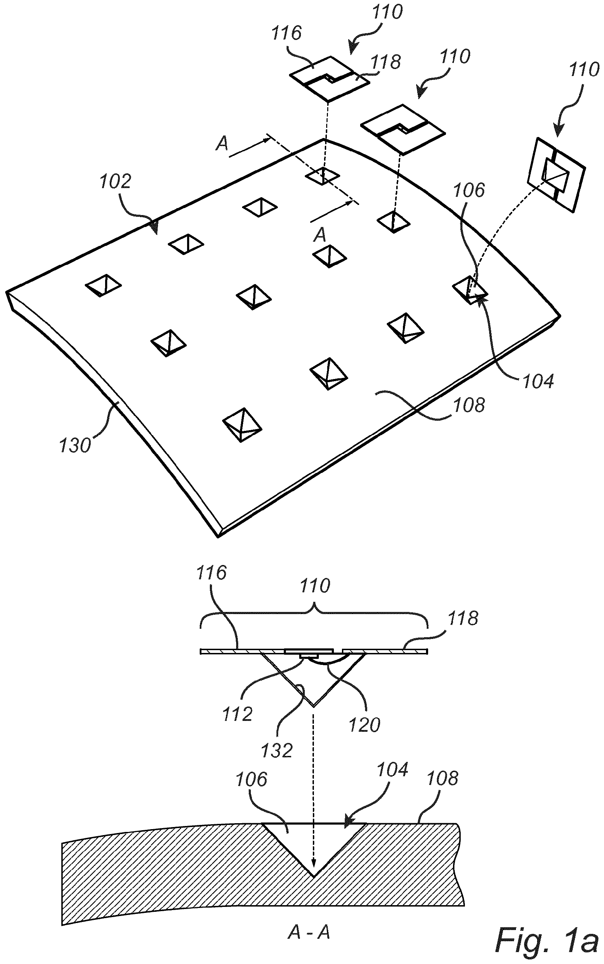

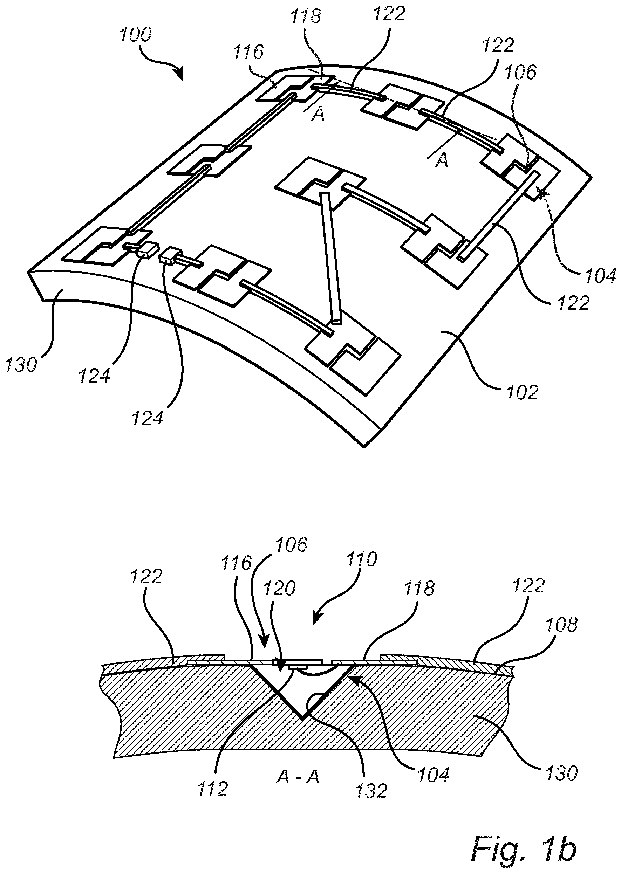

Figs. 1a-b illustrate a manufacturing process for the lighting device 100. The final lighting device 100 is shown in Fig. 1b. Fig. 1a shows a template 102 having a plurality of cavities 104 distributed across the template. The cavities 104 each have an opening 106 in a top surface 108 of the template 102. Furthermore, in Fig. 1a there is shown a plurality of light source packages 110 of which a cross-sectional view of one light source package 110 is shown in a close up view. The light source package 110 comprises a light source 112, and a first electrode 116 and a second electrode 118 electrically connected to the light source. In this exemplary embodiment, the second electrode 118 is connected to the light source via a bond wire 120. Furthermore, a shape of the light source package 110 matches a shape of the cavity 104, in this case a pyramid shape. Referring now to Fig. 1b, where the light source packages 110 have been arranged in the cavities 104. The first 116 and second 118 electrodes are exposed at the opening 106 of the cavity 104. After the light source packages 110 have been arranged in the cavities 104, electrical conductors 122 are applied on the top surface 108 of the template 102. The electrical conductors 122 contact the first electrode 116 and the second electrode 118. Furthermore, the electrical conductors contact power input leads 124. Moreover, the electrical conductors 122 provide galvanic contacts. The template may have any shape, for example curved or in other ways non-planar.

In one embodiment, the template 102 is part of a supporting structure 130. The supporting structure 130 may for example be a main mechanical carrier for a final lighting device product. In this example, the cavities 104 are made directly in the supporting structure 130. The supporting structure 130 with the cavities 104 may be manufactured using e.g. 3D printing based on for example polymer/ABS printing.

Furthermore, in one exemplary embodiment, a reflective bottom layer 132 is comprised in each light source package 110. As shown in Figs. 1a-b, the light source is arranged "upside-down" in the cavity wherein a light emitting surface of the light source 112 faces the reflective bottom layer and an inner surface of the cavity 104. The reflective bottom layer 132 is thus used for reflecting the light emitted by the light source 112 back towards the opening 106 of the cavity 104. Furthermore, the light source 112 is arranged under the first electrode 116. Naturally, the light source 112 may equally well be arranged under the second electrode 118. This way, the light source 112 is hidden behind the first electrode 116 such that the light source 112 is "out-of-sight" of the emitted light. In embodiments the first and/or second electrodes of the light source package are at least partly transparent.

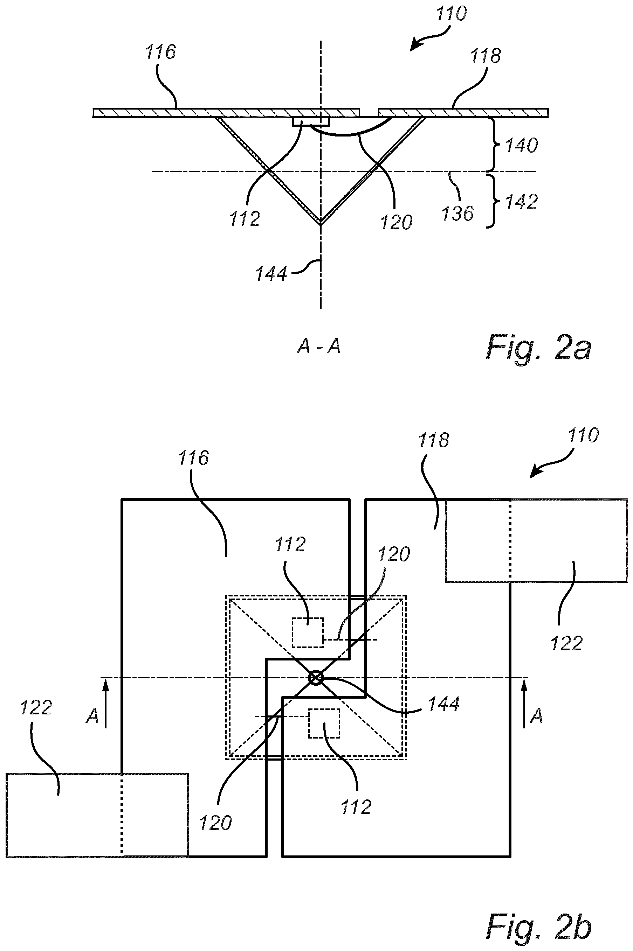

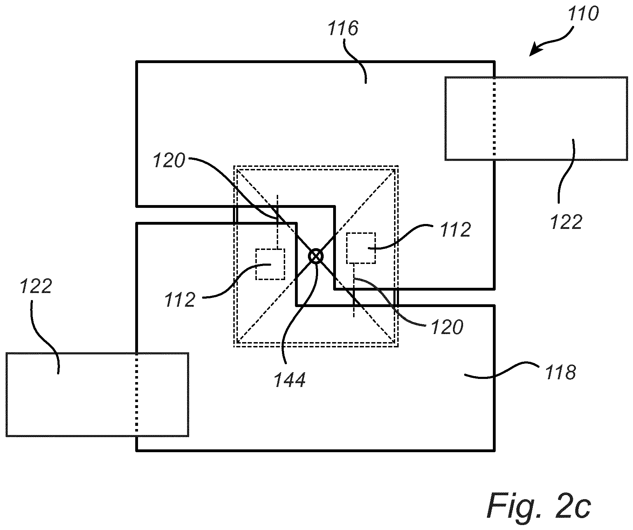

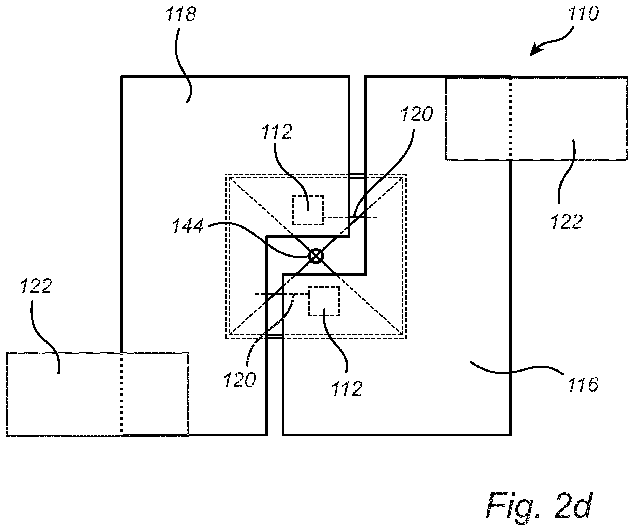

Fig. 2a shows a cross-sectional view of a light source package 110, and figures 2b-2d show top views of a light source package 110 at different rotational positions. In Fig. 2b, there is shown two light sources 112 both connected to the first electrode 116 and to the second electrode118. Similarly to Fig 1a-b, there are shown bond wires 120. In Fig. 2a it can be seen that a top portion 140 and a bottom portion 142 of the light source package 110 are separated by a hypothetical line 136. The top portion 140 and the bottom portion 142 of the light source package 110 are asymmetrical with respect to each other. In this way, during arrangement of the light source packages 110 in the cavities 104, it is ensured that the light source packages 110 are correctly positioned in the cavities, thus that the light source packages 110 are not positioned upside-down and are arranged in the cavities with the required orientation. Note that the line 136 may be drawn anywhere as long as it defines a top 140 and a bottom 142 portion, and still the asymmetry condition is fulfilled. Furthermore, as shown in the sequential figures 2b-2d the light source package is rotationally symmetric along around a top-bottom axis 144, the axis 144 also being shown in Fig. 2a. Fig. 2c shows the light source package after a 90° rotation around the top-bottom axis 144 compared to the light source package shown in Fig. 2b, and Fig. 2d shows the light source package after a 180° rotation around the top-bottom axis 144 compared to the light source package shown in Fig. 2b. The symmetry around the top-bottom axis 144 ensures that the light source packages 110 may be arranged in any one of the rotational positions of figures 2b-2d and still properly positioning the light source package 110 such that the electrical conductors 122 will be aligned with the electrodes 116, 118. Thus, any one of the positions of figures 2b-2d is suitable for contacting the light source packages with the electrical conductors 122. In fact, functionally, there is no difference between the different rotational positions shown in figures 2b-2d. Furthermore, although Figs. 2b-d show light source packages comprising two light sources 112, the light source package 110 may equally well have only one light source 112.

Furthermore, in the embodiment depicted in Figs 1-2, the first and second electrodes 116 and 118 of the light source packages 110 extend onto the top surface 108 of the template 106. In this way, the light source 112 is easily contacted by the electrical conductors 122, without the need for a 'trench-crossing' process. These extended first and second electrodes 116, 118 may also be referred to as extended lead frame pads.

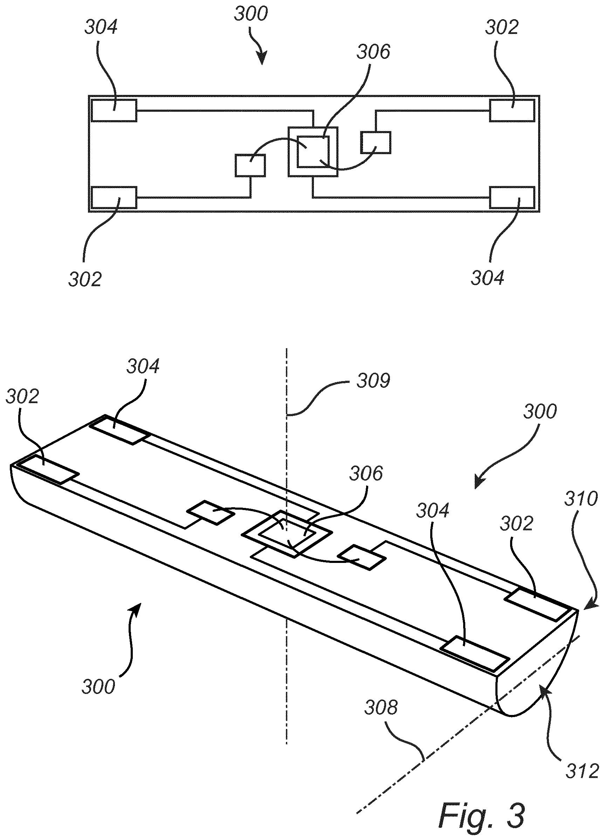

As shown in the embodiments depicted in Figs. 1-2, light source package 110 comprises a cross-section comprising a V-shape. For example, as shown in Fig. 1, the light source package 110 has a pyramidal shape. Naturally, other shapes are possible. For example, as shown in Fig. 3, a U-shape gives the light source package 300 a half-cylinder shape. In the embodiment shown in Fig. 3, one light source 306 of the light source package 300 is connected to electrodes 302 and 304. With this half-cylinder shape and the arrangement of the electrodes 302 and 304, a 180° rotational symmetry is enabled around the top-bottom axis 309. Furthermore, a top portion 310 and a bottom portion 312 are defined by the hypothetical line 308. The top portion 310 and the bottom portion 312 are asymmetrical with respect to each other. In this way, during arrangement of the light source package 300 in a corresponding cavity having a shape matching the shape of the light source package 300, it is ensured that the light source package 300 is correctly positioned in the cavity, thus that the light source packages 300 are positioned according to the required and desired right orientation and not positioned upside-down. Note that the line 308 may be drawn anywhere as long as it defines a top 310 and a bottom 312 portion, and still the asymmetry condition is fulfilled.

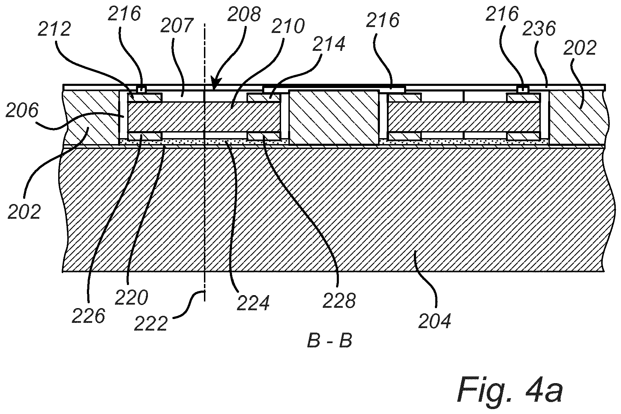

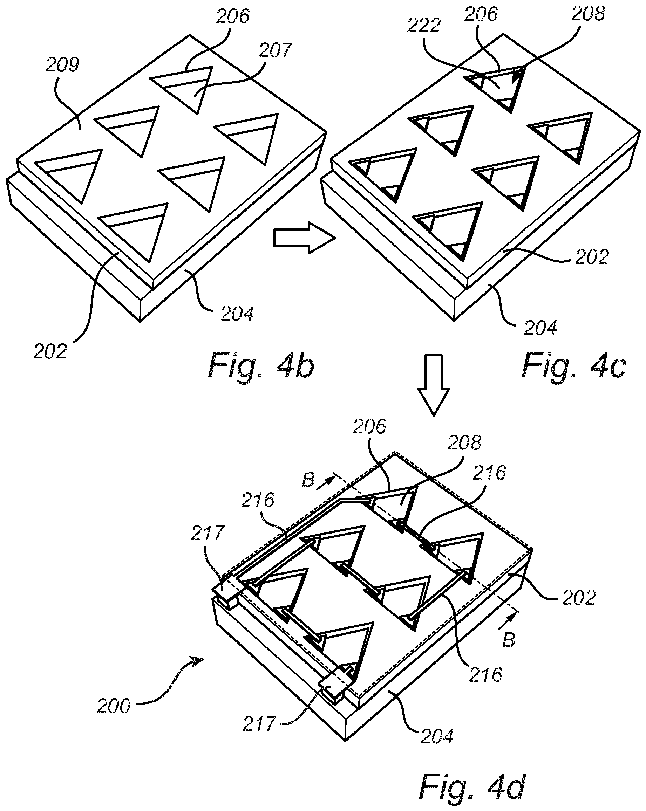

Fig. 4a shows a cross-section of an embodiment of a lighting device 200 shown in Fig. 4d and Figs 4b-d illustrate schematic step for manufacturing the lighting device 200. In this embodiment, a template 202 is provided as a separate template layer 202. The template layer 202 is arranged on a supporting structure 204. The template layer 202 comprises cavities 206 having an opening 207 in a top surface 209 of the template layer 202. A light source package 208 is arranged in each cavity 206, as shown in for example in Fig. 4a or Fig. 4c-d. The light source package 208 comprises a light source 210 having a first top electrode 212 and a second top electrode 214. After the light source packages 208 have been arranged in the cavities 206, electrical conductors 216 are applied on the top surface 209 of the template layer 202. The electrical conductors 216 contact the top electrodes 212, 214 of the light source packages 208. Furthermore, the electrical conductors 216 contact power input pads 217. The electrical conductors provide galvanic connections.

The template layer 202 may be applied using e.g. a wetting/de-wetting process, or patterning processes. Moreover, the template layer 202 may be made from e.g. silicone, epoxy, polyurethaan (PUR), or may be a hot melt type material which allows reflowing of the material to close gaps between the template layer 202 and the light source packages 208, etc.

In addition, the shape of the cavities 206 matches the shape of the light source packages 208. In one embodiment, the shape of each light source package 208 is rotationally asymmetric around a top-bottom axis 222. In this way, the light source package 208 only fits in the cavity in one distinct rotational position. Furthermore, a self-assembly and self-alignment approach for mounting the light source packages 206 in the cavities is facilitated by the asymmetry around the top-bottom axis 222 because the light source packages are only allowed to be mounted in one distinct way and orientation. The light source packages 208 may for example have the shape of an isosceles triangle. Furthermore, in some embodiments, the light source package 206 comprises two light sources arranged such that a first light source is a top light source and a second light source is a bottom light source. For example, the bottom light source has bottom electrodes 226 and 228 and the top light source has top electrodes 212 and 214, wherein the bottom electrodes 226, 228 are arranged on a surface of the light source package 210 that is opposite to a surface of the light source package on which the top electrodes 212, 214 are arranged. With the two light sources the orientation of the light source package in an up-down manner may be disregarded since regardless of the up-down orientation, there is always a light source with electrodes facing the right way (exposed at the opening of the cavity) wherein the electrodes can be contacted to the electrical conductors 216. Thus, the light source package 110 may be arranged in the cavity with the bottom electrodes 226, 228 being exposed at the opening of the cavity or with the top electrodes 212, 214 being exposed at the opening of the cavity.

In the cavities 206, there is further an adhesion element 224 arranged to attach the light source package 208 in the cavity. The adhesion element 224 is configured to allow the light source package to be removed or depart from the cavity if not positioned correctly. For example, for final adhesion of the light source package 208 in the cavity 206, the adhesion element 224 may be re-melted or activated using pressure.

Furthermore, there is a reflective bottom layer 220 arranged beneath the template layer 202, i.e. in between the template layer 202 and the supporting structure 204 in the cavities. The reflective bottom layer 220 has been applied before arranging the template layer 202 on the supporting structure 204.

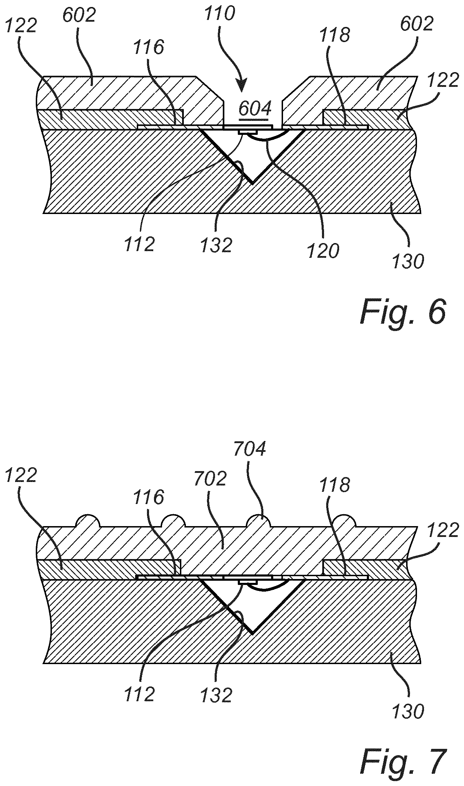

In addition, in this embodiment a top layer 236 is applied in a subsequent step. The function of the top layer will be described with reference to Figs. 6-7.

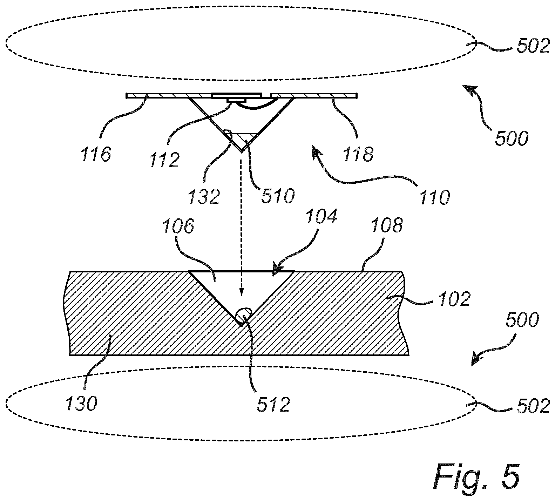

Fig. 5 schematically illustrates arranging a light source package 110 in a cavity 104. Although the light source package 110 is shown as the light source package in Figs. 1-2, the illustrated method is equally applicable to the light source package 208, cavity 206 and template layer 202 shown in Fig. 4a-d. In Fig. 5 a magnetic field generator 500 is arranged to apply a magnetic field such that the light source package 110 is attracted towards the cavity 104. The magnetic field is applied between the opposite magnetic field generator parts 502 of the magnetic field generator 500. In order for the applied magnetic field to attract the light source package 110 towards the cavity 104, the light source package 110 comprises a magnetic element. In a first exemplary embodiment, the electrodes 116 and 118 of the light source package comprise a magnetic element. For example, the electrodes 116, 118 may have a magnetic surface coating or be entirely made from a magnetic material such as e.g. Fe or Ni. In another exemplary embodiment, the bottom reflective layer 132 further comprises a ferromagnetic layer. In yet another embodiment, a separate magnetic element 510 is arranged in the light source package 110. In other embodiments a permanent magnetic field may be present generated by one or more permanent magnets in the template and/or supporting structure.

As the magnetic field is applied, the light source package 110 is pulled into the cavity 104. Furthermore, an adhesion element 512 is placed in the cavity in a preceding step. The adhesion element 512 is configured to attach the light source package 110 in the cavity 104 if the light source package 110 is properly fitted in the cavity 104. For example, for final adhesion of the light source package 110 in the cavity 104 the adhesion element 512 may be re-melted or activated using pressure. In one embodiment, a cyclic magnetic field is applied. With a cyclic magnetic field, badly oriented and/or light source packages that are not fitted in a cavity may be removed from the template 102 or 202 and in the next cycle be re-fitted. In one embodiment, the light source package 110 and the template is arranged in a fluid when applying the magnetic field. This allows a more controlled motion of the light source packages when the applied magnetic field is on. The fluid may be a liquid; however, naturally, the liquid should not harm the light source packages.

Figs. 6-7 show cross-sectional views of part of a lighting device, similar to what is shown in Figs. 1-2. However, in Figs. 6 and 7 respective top layers 602 and 702 are applied after the light source package 110 has been arranged in the cavity. In Fig. 6, the top layer 602 has a through-hole 604 at the location of the light source package 110. The through-hole 604 is configured for beam-shaping or beam-manipulation. In other words, the top layer 602 hides all parts (electrical conductors 122, electrodes 116, 118, supporting structure 130) except for the part where light emitted by the light source 112 is emitted out from the light source package 110.

In Fig. 7, additional structures 704 in the top layer 702 including local (3D) variation in composition (e.g. refractive index, scattering, embedded phosphors for color conversion, etc.) and structure (e.g. micro-lenses, out coupling micro-structures, Fresnel optics, meso-optics, etc.) provides for optical functionality. The described functionality of the top layer of Figs. 6-7 also applies to the top layer 236 in Fig. 4a.

In each of the above described exemplary embodiments of the present invention, the light source of the light source packages may advantageously be a light-emitting diode (LED). Furthermore, a light source package may comprise more than one light source, for example two light sources electrically connected in an anti-parallel fashion or an array of light sources connected in series or in parallel. Furthermore, applying the electrical conductors comprises using a printing process. The electrical conductors 216, 122 may be made from e.g. a metal paste. The metal may for example be silver (Ag).

Additionally, variations to the disclosed embodiments can be understood and effected by the skilled person in practicing the claimed invention, from a study of the drawings, the disclosure, and the appended claims. For example, the present invention is equally applicable to planar surfaces.

In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A lighting device (100, 200, 300) comprising:
a template (102, 202) comprising a plurality of cavities (104, 206) distributed across the template (102, 202), wherein each cavity (104, 206) has an opening (106, 207) in a top surface (108, 209) of the template (102, 202);
a plurality of light source packages (110, 208, 300), each comprising a light source (112, 210), arranged in the plurality of cavities (104, 206), wherein each of the light source packages (110, 208, 300) has a shape matching a shape of a corresponding cavity (104, 206), and wherein each of the light source packages (110, 208, 300) has a first electrode (116, 212, 302) and a second electrode (118, 216, 304) arranged at a top surface of the light source package (110, 208, 300), the first and second electrodes being exposed at the opening (106, 207) of the cavity (104, 206) and electrically connected to the light source (112, 210); and
electrical conductors (122, 216) applied on the top surface (108, 209) of the template (102, 202), the electrical conductors (122, 216) contacting the first and second electrodes (116, 212, 302, 118, 216, 304) of the light source packages (110, 208, 300) for electrically connecting the light source packages (110, 208, 300),
**characterized in that** the light source packages (110, 208, 300) or the plurality of cavities comprise a reflective bottom layer (132, 220) and wherein a light emitting surface of the light source (112, 210) faces the reflective bottom layer (132, 220).

2. The lighting device according to claim 1, wherein the template (102, 202) is part of a supporting structure (130).

3. The lighting device according to claim 1 or 2, wherein the light source packages (110, 208, 300) comprise a magnetic element.

4. The lighting device according to any one of claims 1 to 3, wherein the first and second electrodes of the light source packages (110, 208, 300) extend onto the top surface (108, 209) of the template (102, 202).

5. The lighting device according to any of the previous claims, wherein a top portion (140) of the light source packages (110, 208, 300) is asymmetric with respect to a bottom portion (142) of the light source packages (110, 208, 300), and wherein the shape of each of the light source packages (110, 208, 300) is rotationally symmetric around a top-bottom axis (144).

6. The lighting device according to any of the previous claims, wherein the first and second electrodes (116, 212, 302, 118, 216, 304) of the light source packages (110, 208, 300) extend onto the top surface (108, 209) of the template (102, 202).

7. The lighting device according to any of the previous claims, wherein the template (102, 202) is a separate template layer (202), which is arranged on a supporting structure (204).

8. The lighting device according to any of the previous claims, wherein each light source package (110, 208, 300) comprises a top light source electrically connected to a first top electrode (212) and a second top electrode (214) and a bottom light source electrically connected to a first bottom electrode (226) and a second bottom electrode (228), wherein the first and second bottom electrodes (212, 214) are arranged on a surface of the light source package (110, 208, 300) that is opposite to a surface on which the first and second top electrodes (226, 228) are arranged.

9. The lighting device according to any of the previous claims, wherein the shape of the light source package (110, 208, 300) is rotationally asymmetric around a top-bottom axis (144).

10. The lighting device according to any of the previous claims, wherein the first electrode (116) of a first light source package of the light source packages (110, 208, 300) is electrically connected to the second electrode (118) of a second light source package of the light source packages (110, 208, 300) by means of at least one electrical conductor (122, 216).

11. The lighting device according to any of the previous claims, wherein the lighting device has a non-planar extension and the template (102, 202) is non-planar.

12. A method for manufacturing a lighting device (100, 200), the method comprising the steps of:
providing a template (102, 202) comprising a plurality of cavities (104, 206) distributed across the template (102, 202), wherein each cavity (104, 206) has an opening (106, 207) in a top surface (108, 209) of the template;
arranging a plurality of light source packages (110, 208, 300), each comprising a light source (112, 210), in the cavities (104, 206), wherein each of the light source packages (110, 208, 300) has a shape matching a shape of a corresponding cavity (104, 206), each of the light source packages (110, 208, 300) having a first electrode (116, 212, 302) and a second electrode (118, 216, 304) electrically connected to the light source (112, 210), the first and the second electrodes (116, 212, 302, 118, 216, 304) arranged at a first surface of the light source package (110, 208, 300) and being exposed at the opening (106) of the cavity when the plurality of light source packages (110, 208, 300) are arranged in the cavities (104); and
after arranging the plurality of light source packages (110, 208, 300) in the cavities (104, 206), applying electrical conductors (122, 216) on the top surface (108, 209) of the template (102, 202), the electrical conductors (122, 216) contacting the first and second electrodes (116, 212, 302, 118, 216, 304) of the light source packages (110, 208, 300) for electrically connecting the light source packages (110, 208, 300),
wherein the light source packages (110, 208, 300) or the plurality of cavities comprise a reflective bottom layer (132, 220) and wherein a light emitting surface of the light source (112, 210) faces the reflective bottom layer (132, 220).

13. The method according to claim 12, further comprising the step of:
providing an adhesion element (224, 512) in the cavities (104, 206) before each of the light source packages (110, 208, 300) is arranged in the corresponding cavity (104, 206), wherein the adhesion element (224, 512) is configured to attach each of the light source packages (110, 208, 300) in the corresponding cavity (104, 206).

14. The method according to claim 12, wherein the light source package comprises a magnetic element, wherein the step of arranging the light source packages (110, 208, 300) further comprises:
applying a magnetic field such that the light source packages (110, 208, 300) are attracted towards the cavities (104, 206) of the template (102, 202).

15. The method according to claim 12, 13 or 14, wherein the step of applying electrical conductors (122, 216) comprises forming conductor lines using a printing process.

## Patentansprüche

1. Beleuchtungsvorrichtung (100, 200, 300), umfassend:
eine Schablone (102, 202) mit mehreren über die Schablone (102, 202) verteilten Hohlräumen (104, 206), wobei jeder Hohlraum (104, 206) eine Öffnung (106, 207) in einer Oberseite (108, 209) der Schablone (102, 202) aufweist;
mehrere Lichtquellen-Packages (110, 208, 300), von denen jedes eine in den mehreren Hohlräumen (104, 206) angeordnete Lichtquelle (112, 210) umfasst, wobei jedes der Lichtquellen-Packages (110, 208, 300) eine einer Form eines entsprechenden Hohlraumes (104, 206) entsprechende Form aufweist, und wobei jedes der Lichtquellen-Packages (110, 208, 300) eine erste Elektrode (116, 212, 302) sowie eine zweite Elektrode (118, 216, 304) aufweist, die auf einer Oberseite des Lichtquellen-Package (110, 208, 300) angeordnet ist, wobei die erste und zweite Elektrode an der Öffnung (106, 207) des Hohlraumes (104, 206) freigelegt und mit der Lichtquelle (112, 210) elektrisch verbunden sind; sowie
elektrische Leiter (122, 216), die auf der Oberseite (108, 209) der Schablone (102, 202) aufgebracht sind, wobei die elektrischen Leiter (122, 216) die erste und zweite Elektrode (116, 212, 302, 118, 216, 304) der Lichtquellen-Packages (110, 208, 300) kontaktieren, um die Lichtquellen-Packages (110, 208, 300) elektrisch zu verbinden,
**dadurch gekennzeichnet, dass**
die Lichtquellen-Packages (110, 208, 300) oder die mehreren Hohlräume eine reflektive, untere Schicht (132, 220) umfassen, und wobei eine lichtemittierende Oberfläche der Lichtquelle (112, 210) der reflektiven, unteren Schicht (132, 220) zugewandt ist.

2. Beleuchtungsvorrichtung nach Anspruch 1, wobei die Schablone (102, 202) Teil einer Trägerstruktur (130) ist.

3. Beleuchtungsvorrichtung nach Anspruch 1 oder 2, wobei die Lichtquellen-Packages (110, 208, 300) ein Magnetelement umfassen.

4. Beleuchtungsvorrichtung nach einem der Ansprüche 1 bis 3, wobei sich die erste und zweite Elektrode der Lichtquellen-Packages (110, 208, 300) bis auf die Oberseite (108, 209) der Schablone (102, 202) erstrecken.

5. Beleuchtungsvorrichtung nach einem der vorangegangenen Ansprüche, wobei ein oberer Teil (140) der Lichtquellen-Packages (110, 208, 300) gegenüber einem unteren Teil (142) der Lichtquellen-Packages (110, 208, 300) asymmetrisch ist, und wobei die Form von jedem der Lichtquellen-Packages (110, 208, 300) um eine Oben-Unten-Achse (144) rotationssymmetrisch ist.

6. Beleuchtungsvorrichtung nach einem der vorangegangenen Ansprüche, wobei sich die erste und zweite Elektrode (116, 212, 302, 118, 216, 304) der Lichtquellen-Packages (110, 208, 300) bis auf die Oberseite (108, 209) der Schablone (102, 202) erstrecken.

7. Beleuchtungsvorrichtung nach einem der vorangegangenen Ansprüche, wobei die Schablone (102, 202) eine separate Schablonenschicht (202) ist, die auf einer Trägerstruktur (204) angeordnet ist.

8. Beleuchtungsvorrichtung nach einem der vorangegangenen Ansprüche, wobei jedes Lichtquellen-Package (110, 208, 300) eine mit einer ersten oberen Elektrode (212) und einer zweiten oberen Elektrode (214) elektrisch verbundene, obere Lichtquelle sowie eine mit einer ersten unteren Elektrode (226) und einer zweiten unteren Elektrode (228) elektrisch verbundene, untere Lichtquelle umfasst, wobei die erste und zweite untere Elektrode (212, 214) auf einer Oberfläche des Lichtquellen-Package (110, 208, 300) angeordnet sind, die sich gegenüber einer Oberfläche befindet, auf der die erste und zweite obere Elektrode (226, 228) angeordnet sind.

9. Beleuchtungsvorrichtung nach einem der vorangegangenen Ansprüche, wobei die Form des Lichtquellen-Package (110, 208, 300) um eine Oben-Unten-Achse (144) rotationssymmetrisch ist.

10. Beleuchtungsvorrichtung nach einem der vorangegangenen Ansprüche, wobei die erste Elektrode (116) eines ersten Lichtquellen-Package der Lichtquellen-Packages (110, 208, 300) mit der zweiten Elektrode (118) eines zweiten Lichtquellen-Package der Lichtquellen-Packages (110, 208, 300) mit Hilfe von mindestens einem elektrischen Leiter (122, 216) elektrisch verbunden ist.

11. Beleuchtungsvorrichtung nach einem der vorangegangenen Ansprüche, wobei die Beleuchtungsvorrichtung eine nicht-planare Ausdehnung aufweist und die Schablone (102, 202) nicht-planar ist.

12. Verfahren zur Herstellung einer Beleuchtungsvorrichtung (100, 200), wobei das Verfahren die folgenden Schritte umfasst, wonach:
eine Schablone (102, 202) mit mehreren über die Schablone (102, 202) verteilten Hohlräumen (104, 206) vorgesehen wird, wobei jeder Hohlraum (104, 206) eine Öffnung (106, 207) in einer Oberseite (108, 209) der Schablone aufweist;
mehrere Lichtquellen-Packages (110, 208, 300) angeordnet werden, von denen jedes eine Lichtquelle (112, 210) in den Hohlräumen (104, 206) umfasst, wobei jedes der Lichtquellen-Packages (110, 208, 300) eine einer Form eines entsprechenden Hohlraumes (104, 206) entsprechende Form aufweist, wobei jedes der Lichtquellen-Packages (110, 208, 300) eine erste Elektrode (116, 212, 302) sowie eine zweite Elektrode (118, 216, 304) aufweist, die mit der Lichtquelle (112, 210) elektrisch verbunden sind, wobei die erste und die zweite Elektrode (116, 212, 302, 118, 216, 304) an einer ersten Oberfläche des Lichtquellen-Package (110, 208, 300) angeordnet und an der Öffnung (106) des Hohlraumes freigelegt sind, wenn die mehreren Lichtquellen-Packages (110, 208, 300) in den Hohlräumen (104) angeordnet sind; und
nach Anordnen der mehreren Lichtquellen-Packages (110, 208, 300) in den Hohlräumen (104, 206) elektrische Leiter (122, 216) auf der Oberseite (108, 209) der Schablone (102, 202) aufgebracht werden, wobei die elektrischen Leiter (122, 216) die erste und zweite Elektrode (116, 212, 302, 118, 216, 304) der Lichtquellen-Packages (110, 208, 300) kontaktieren, um die Lichtquellen-Packages (110, 208, 300) elektrisch zu verbinden,
wobei die Lichtquellen-Packages (110, 208, 300) oder die mehreren Hohlräume eine reflektive, untere Schicht (132, 220) umfassen, und wobei eine lichtemittierende Oberfläche der Lichtquelle (112, 210) der reflektiven, unteren Schicht (132, 220) zugewandt ist.

13. Verfahren nach Anspruch 12, das weiterhin den Schritt umfasst, wonach:
ein Adhäsionselement (224, 512) in den Hohlräumen (104, 206) vorgesehen wird, bevor jedes der Lichtquellen-Packages (110, 208, 300) in dem entsprechenden Hohlraum (104, 206) angeordnet wird, wobei das Adhäsionselement (224, 512) so konfiguriert ist, dass es jedes der Lichtquellen-Packages (110, 208, 300) in dem entsprechenden Hohlraum (104, 206) befestigt.

14. Verfahren nach Anspruch 12, wobei das Lichtquellen-Package ein Magnetelement umfasst, wobei der Schritt des Anordnens der Lichtquellen-Packages (110, 208, 300) weiterhin umfasst:
das Anlegen eines Magnetfeldes, so dass die Lichtquellen-Packages (110, 208, 300) zu den Hohlräumen (104, 206) der Schablone (102, 202) hin angezogen werden.

15. Verfahren nach Anspruch 12, 13 oder 14, wobei der Schritt des Aufbringens elektrischer Leiter (122, 216) das Ausbilden von Leiterbahnen unter Anwendung eines Druckvorgangs umfasst.

## Revendications

1. Dispositif d'éclairage (100, 200, 300) comprenant :
un gabarit (102, 202) comprenant une pluralité de cavités (104, 206) réparties à travers le gabarit (102, 202), dans lequel chaque cavité (104, 206) a une ouverture (106, 207) dans une surface haute (108, 209) du gabarit (102, 202) ;
une pluralité de boîtiers de source de lumière (110, 208, 300), comprenant chacun une source de lumière (112, 210), agencés dans la pluralité de cavités (104, 206), dans lequel chacun des boîtiers de source de lumière (110, 208, 300) a une forme concordant avec une forme d'une cavité (104, 206) correspondante, et dans lequel chacun des boîtiers de source de lumière (110, 208, 300) a une première électrode (116, 212, 302) et une seconde électrode (118, 216, 304) agencées au niveau d'une surface haute du boîtier de source de lumière (110, 208, 300), les première et seconde électrodes étant exposées au niveau de l'ouverture (106, 207) de la cavité (104, 206) et connectées électriquement à la source de lumière (112, 210) ; et
des conducteurs électriques (122, 216) appliqués sur la surface haute (108, 209) du gabarit (102, 202), les conducteurs électriques (122, 216) venant en contact avec les première et seconde électrodes (116, 212, 302, 118, 216, 304) des boîtiers de source de lumière (110, 208, 300) pour connecter électriquement les boîtiers de source de lumière (110, 208, 300),
**caractérisé en ce que**
les boîtiers de source de lumière (110, 208, 300) ou la pluralité de cavités comprennent une couche basse réfléchissante (132, 220) et dans lequel une surface d'émission de lumière de la source de lumière (112, 210) fait face à la couche basse réfléchissante (132, 220).

2. Dispositif d'éclairage selon la revendication 1, dans lequel le gabarit (102, 202) fait partie d'une structure de support (130).

3. Dispositif d'éclairage selon la revendication 1 ou 2, dans lequel les boîtiers de source de lumière (110, 208, 300) comprennent un élément magnétique.

4. Dispositif d'éclairage selon l'une quelconque des revendications 1 à 3, dans lequel les première et seconde électrodes des boîtiers de source de lumière (110, 208, 300) s'étendent sur la surface haute (108, 209) du gabarit (102, 202).

5. Dispositif d'éclairage selon l'une quelconque des revendications précédentes, dans lequel une portion haute (140) des boîtiers de source de lumière (110, 208, 300) est asymétrique par rapport à une portion basse (142) des boîtiers de source de lumière (110, 208, 300), et dans lequel la forme de chacun des boîtiers de source de lumière (110, 208, 300) est symétrique en rotation autour d'un axe haut-bas (144).

6. Dispositif d'éclairage selon l'une quelconque des revendications précédentes, dans lequel les première et seconde électrodes (116, 212, 302, 118, 216, 304) des boîtiers de source de lumière (110, 208, 300) s'étendent sur la surface haute (108, 209) du gabarit (102, 202).

7. Dispositif d'éclairage selon l'une quelconque des revendications précédentes, dans lequel le gabarit (102, 202) est une couche de gabarit séparée (202), qui est agencée sur une structure de support (204).

8. Dispositif d'éclairage selon l'une quelconque des revendications précédentes, dans lequel chaque boîtier de source de lumière (110, 208, 300) comprend une source de lumière haute connectée électriquement à une première électrode haute (212) et à une seconde électrode haute (214) et une source de lumière basse connectée électriquement à une première électrode basse (226) et à une seconde électrode basse (228), dans lequel les première et seconde électrodes basses (212, 214) sont agencées sur une surface du boîtier de source de lumière (110, 208, 300) qui est opposée à une surface sur laquelle les première et seconde électrodes hautes (226, 228) sont agencées.

9. Dispositif d'éclairage selon l'une quelconque des revendications précédentes, dans lequel la forme du boîtier de source de lumière (110, 208, 300) est asymétrique en rotation autour d'un axe haut-bas (144).

10. Dispositif d'éclairage selon l'une quelconque des revendications précédentes, dans lequel la première électrode (116) d'un premier boîtier de source de lumière des boîtiers de source de lumière (110, 208, 300) est connectée électriquement à la seconde électrode (118) d'un second boîtier de source de lumière des boîtiers de source de lumière (110, 208, 300) au moyen d'au moins un conducteur électrique (122, 216).

11. Dispositif d'éclairage selon l'une quelconque des revendications précédentes, dans lequel le dispositif d'éclairage a une extension non plane et le gabarit (102, 202) est non plan.

12. Procédé de fabrication d'un dispositif d'éclairage (100, 200), le procédé comprenant les étapes de :
fourniture d'un gabarit (102, 202) comprenant une pluralité de cavités (104, 206) réparties à travers le gabarit (102, 202), dans lequel chaque cavité (104, 206) a une ouverture (106, 207) dans une surface haute (108, 209) du gabarit ;
agencement d'une pluralité de boîtiers de source de lumière (110, 208, 300), comprenant chacun une source de lumière (112, 210), dans les cavités (104, 206), dans lequel chacun des boîtiers de source de lumière (110, 208, 300) a une forme concordant avec une forme d'une cavité (104, 206) correspondante, chacun des boîtiers de source de lumière (110, 208, 300) ayant une première électrode (116, 212, 302) et une seconde électrode (118, 216, 304) connectées électriquement à la source de lumière (112, 210), les première et seconde électrodes (116, 212, 302, 118, 216, 304) étant agencées au niveau d'une première surface du boîtier de source de lumière (110, 208, 300) et étant exposées au niveau de l'ouverture (106) de la cavité lorsque la pluralité de boîtiers de source de lumière (110, 208, 300) sont agencés dans les cavités (104) ; et
après agencement de la pluralité de boîtiers de source de lumière (110, 208, 300) dans les cavités (104, 206), application de conducteurs électriques (122, 216) sur la surface haute (108, 209) du gabarit (102, 202), les conducteurs électriques (122, 216) venant en contact avec les première et seconde électrodes (116, 212, 302, 118, 216, 304) des boîtiers de source de lumière (110, 208, 300) pour connecter électriquement les boîtiers de source de lumière (110, 208, 300),
dans lequel les boîtiers de source de lumière (110, 208, 300) ou la pluralité de cavités comprennent une couche basse réfléchissante (132, 220) et dans lequel une surface d'émission de lumière de la source de lumière (112, 210) fait face à la couche basse réfléchissante (132, 220).

13. Procédé selon la revendication 12, comprenant en outre l'étape de :
fourniture d'un élément d'adhérence (224, 512) dans les cavités (104, 206) avant que chacun des boîtiers de source de lumière (110, 208, 300) soit agencé dans la cavité (104, 206) correspondante, dans lequel l'élément d'adhérence (224, 512) est configuré pour attacher chacun des boîtiers de source de lumière (110, 208, 300) dans la cavité (104, 206) correspondante.

14. Procédé selon la revendication 12, dans lequel le boîtier de source de lumière comprend un élément magnétique, dans lequel l'étape d'agencement des boîtiers de source de lumière (110, 208, 300) comprend en outre :
l'application d'un champ magnétique de sorte que les boîtiers de source de lumière (110, 208, 300) soient attirés vers les cavités (104, 206) du gabarit (102, 202).

15. Procédé selon la revendication 12, 13 ou 14, dans lequel l'étape d'application de conducteurs électriques (122, 216) comprend la formation de pistes conductrices à l'aide d'un processus d'impression.
